(19) Europäisches Patentamt
European Patent Office
Office européen des brevets

(11) **EP 3 436 807 B1**

(12) **FASCICULE DE BREVET EUROPEEN**

(45) Date de publication et mention de la délivrance du brevet:
**02.12.2020 Bulletin 2020/49**

(21) Numéro de dépôt: **17715055.4**

(22) Date de dépôt: **14.03.2017**

(51) Int Cl.:
***G01N 21/95*** *(2006.01)*

(86) Numéro de dépôt international:
**PCT/EP2017/055967**

(87) Numéro de publication internationale:
**WO 2017/167573 (05.10.2017 Gazette 2017/40)**

(54) **PROCEDE ET SYSTEME D'INSPECTION PAR EFFET DOPPLER LASER DE PLAQUETTES POUR LA MICROELECTRONIQUE OU L'OPTIQUE**

VERFAHREN UND SYSTEM ZUR INSPEKTION VON PLATTEN FÜR DIE MIKROELEKTRONIK ODER OPTIK DURCH LASER-DOPPLER-EFFEKT

METHOD AND SYSTEM FOR INSPECTING BOARDS FOR MICROELECTRONICS OR OPTICS BY LASER DOPPLER EFFECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.03.2016 FR 1652835**

(43) Date de publication de la demande:
**06.02.2019 Bulletin 2019/06**

(73) Titulaire: **Unity Semiconductor**
**38330 Montbonnot-Saint-Martin (FR)**

(72) Inventeurs:
• **GASTALDO, Philippe**
**38530 Pontcharra (FR)**
• **DURAND DE GEVIGNEY, Mayeul**
**38240 Meylan (FR)**
• **COMBIER, Tristan**
**38000 Grenoble (FR)**

(74) Mandataire: **IPAZ**
**Parc Les Algorithmes, Bâtiment Platon**
**CS 70003 Saint-Aubin**
**91192 Gif-sur-Yvette Cedex (FR)**

(56) Documents cités:
**WO-A1-2016/050735      WO-A1-2016/050738**
**WO-A2-02/39099        US-A- 5 343 290**
**US-A- 5 710 629        US-A- 5 883 714**

**Description**

**DOMAINE DE L'INVENTION**

La présente invention concerne un procédé et un système d'inspection par effet Doppler laser de plaquettes pour la microélectronique ou l'optique.

**ARRIERE PLAN DE L'INVENTION**

Lors de la fabrication et l'utilisation de plaquettes (ou « wafers » selon la terminologie anglo-saxonne) pour la microélectronique ou l'optique, il est habituel de réaliser une inspection de la surface de chaque plaquette afin d'y détecter d'éventuels défauts et de déceler la ou les étapes générant ces défauts.

Par ailleurs, l'inspection ne vise généralement pas uniquement à déceler la présence ou non de défauts, mais aussi à fournir des informations qualitatives et/ou quantitatives sur lesdits défauts, telles que leur localisation, leur taille et/ou leur nature, par exemple.

Pour ces impératifs de sensibilité et surtout de répétabilité et de stabilité de mesure, une inspection visuelle par un opérateur n'est pas suffisante.

Des systèmes d'inspection ont donc été développés en vue de détecter des défauts de plus en plus petits et de fournir toutes informations requises sur la nature, la taille, la localisation, etc. desdits défauts.

Ces systèmes doivent en outre permettre une durée d'inspection de chaque plaquette qui soit suffisamment courte pour ne pas pénaliser les cadences de fabrication.

A cet effet, une technique connue d'inspection de plaquettes est la microscopie en champ sombre (« dark field » selon la terminologie anglo-saxonne), qui consiste à émettre à partir d'une source lumineuse un faisceau en direction de la plaquette et à mesurer l'intensité de la lumière diffusée par la surface et ce qui est présent sur cette dernière. Une variation de l'intensité diffusée révèle donc la présence d'un défaut à la surface de la plaquette.

Le document WO 02/39099 décrit un système dark field d'inspection de plaquettes semi-conductrices reposant sur la vélocimétrie laser à effet Doppler (LDV, acronyme du terme anglo-saxon « Laser Doppler Velocimetry »).

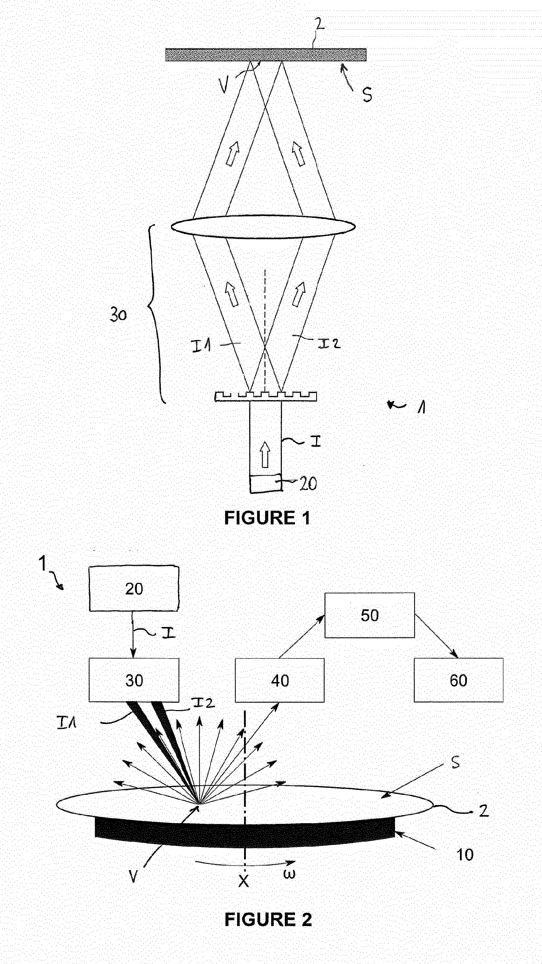

Comme on peut le voir sur la figure 1, un tel système 1 comprend une source lumineuse 20 et un dispositif interférométrique 30 couplé à la source lumineuse agencé en regard de la surface S de la plaquette 2 à inspecter, qui est animée d'un mouvement de rotation. Afin de former le dispositif interférométrique, un dispositif est utilisé pour diviser le faisceau I issu de la source lumineuse 20 en deux faisceaux incidents I1, I2. A la sortie de ce diviseur, les deux faisceaux I1, I2 sont orientés l'un par rapport à l'autre de sorte à former, à leur intersection, un volume de mesure V comprenant une pluralité de franges d'interférence parallèles. Le système 1 est conçu pour que la surface S de la plaquette passe dans ledit volume de mesure lors de son mouvement. La lumière diffusée à la surface de la plaquette est collectée par des miroirs et dirigée vers un dispositif d'acquisition couplé à un module de détection (non représenté).

La présence d'un défaut sur la surface de la plaquette se traduit, lorsque ce défaut traverse les franges d'interférences, par la diffusion d'une bouffée Doppler mesurée par le module de détection. Une bouffée Doppler est un signal présentant une double composante fréquentielle : une composante de fréquence basse, formant l'enveloppe du signal, correspondant à l'intensité lumineuse moyenne diffusée par le défaut, et une composante de fréquence haute, correspondant à la fréquence Doppler contenant l'information sur la vitesse du défaut. La fréquence Doppler $f_D$ est liée à la vitesse v de déplacement du défaut dans la direction perpendiculaire aux franges et à la distance $\Delta$ entre les franges d'interférences (ou distance interfranges) par la relation : $v = f_D * \Delta$.

Le document WO 2009/112704 décrit un autre système d'inspection de plaquettes basé sur la vélocimétrie laser à effet Doppler.

Dans le cas du document WO 02/39099, le volume de mesure produit, sur la surface de la plaquette, une tache elliptique dont le grand axe est orienté dans la direction radiale de la plaquette, les franges d'interférence s'étendant transversalement à la trajectoire de rotation de la plaquette. La largeur de la tache elliptique est choisie suffisamment faible (40 $\mu$m) pour permettre de détecter précisément la position angulaire du défaut par rapport à un point de référence de la plaque. La longueur de la tache elliptique est choisie suffisamment grande (2 mm) pour permettre de réduire la durée d'inspection. Par ailleurs, la vitesse d'un défaut étant fonction de sa position radiale, il est possible, en mesurant la fréquence Doppler de ce défaut, de déterminer la position radiale dudit défaut avec une précision plus grande que la taille de la tache.

Toutefois, malgré l'exploitation de la fréquence Doppler, un tel système présente une sensibilité insuffisante pour détecter de très petits défauts (typiquement, de l'ordre de 100 nm ou moins). En outre, ce système ne présente pas une résolution radiale suffisante.

## BREVE DESCRIPTION DE L'INVENTION

Un but de l'invention est de résoudre les problèmes précités et de concevoir un système et un procédé d'inspection de plaquettes qui offre une sensibilité et une résolution radiale supérieures à celles des techniques connues. Notamment, des défauts de taille inférieure à 100 nm doivent pouvoir être détectés. Par ailleurs, ledit procédé doit convenir à la fois aux plaquettes opaques et aux plaquettes au moins partiellement transparentes à la longueur d'onde de la source lumineuse employée.

Conformément à l'invention, il est proposé un procédé d'inspection d'une plaquette pour la microélectronique ou l'optique, comprenant :

- la mise en rotation de la plaquette autour d'un axe de symétrie perpendiculaire à une surface principale de ladite plaquette,
- l'émission, à partir d'une source lumineuse couplée à un dispositif interférométrique, de deux faisceaux lumineux incidents de sorte à former, à l'intersection entre les deux faisceaux, un volume de mesure contenant des franges d'interférences agencées de telle sorte qu'une région de la surface principale de la plaquette traverse au moins une frange du volume de mesure, la dimension dudit volume de mesure dans une direction radiale de la plaquette étant comprise entre 5 et 100 $\mu$m,
- la collecte d'au moins une partie de la lumière diffusée par ladite région de la plaquette,
- l'acquisition de la lumière collectée et l'émission d'un signal électrique représentant la variation de l'intensité lumineuse de la lumière collectée en fonction du temps,
- la détection, dans ledit signal, d'une composante fréquentielle dans ladite lumière collectée, ladite fréquence étant la signature temporelle du passage d'un défaut dans le volume de mesure.

Selon un mode de réalisation, la dimension du volume de mesure dans une direction tangentielle à la trajectoire de rotation de la plaquette est comprise entre 5 et 100 $\mu$m, de préférence entre 15 et 50 $\mu$m.

Selon une forme d'exécution de l'invention, la plaquette est au moins partiellement transparente à la longueur d'onde de la source lumineuse.

La dimension du volume de mesure dans une direction perpendiculaire à la surface de la plaquette est alors avantageusement inférieure ou égale au quart de l'épaisseur de ladite plaquette.

De manière particulièrement avantageuse, à l'emplacement du volume de mesure, les faisceaux incidents présentent une largeur minimale.

Selon un mode de réalisation, la puissance de la source lumineuse est supérieure ou égale à 10 mW.

La longueur d'onde de la source lumineuse est de préférence inférieure ou égale à 900 nm.

Selon un mode de réalisation, l'interfrange est compris entre 0,1 et 10 $\mu$m.

Un autre objet concerne un système d'inspection de plaquettes pour la microélectronique ou l'optique, comprenant :

- un dispositif d'entraînement d'une plaquette en rotation autour d'un axe de symétrie perpendiculaire à une surface principale de ladite plaquette,
- une source lumineuse adaptée pour émettre un faisceau lumineux,
- un dispositif interférométrique couplé à la source lumineuse pour diviser le faisceau émis par ladite source en deux faisceaux et pour former, à l'intersection entre les deux faisceaux, un volume de mesure contenant des franges d'interférences, la dimension dudit volume de mesure dans une direction radiale de la plaquette étant comprise entre 5 et 100 $\mu$m, le dispositif interférométrique et le dispositif d'entraînement étant agencés l'un par rapport à l'autre de sorte qu'une région de la surface principale de la plaquette en rotation traverse au moins une frange du volume de mesure,
- un dispositif de collecte de la lumière diffusée par la plaquette,
- un dispositif d'acquisition de la lumière collectée configuré pour émettre un signal électrique représentant la variation de l'intensité lumineuse de la lumière collectée en fonction du temps,
- un dispositif de traitement configuré pour détecter, dans ledit signal, une composante fréquentielle dans ladite lumière collectée, ladite fréquence étant la signature temporelle du passage d'un défaut dans un volume de mesure respectif et pour déterminer, à partir de ladite fréquence, la position du défaut dans la direction radiale et/ou dans l'épaisseur de la plaquette.

Selon un mode de réalisation, le système comprend en outre un bras pour déplacer le dispositif interférométrique et le dispositif de collecte de la lumière diffusée en translation dans une direction radiale, la source lumineuse, le dispositif d'acquisition et le dispositif de traitement étant immobiles.

De manière avantageuse, ledit dispositif interférométrique est couplé à la source lumineuse par une fibre optique et ledit dispositif de collecte est couplé au dispositif d'acquisition par une fibre optique.

## BREVE DESCRIPTION DES DESSINS

D'autres caractéristiques et avantages de l'invention ressortiront de la description détaillée qui va suivre, en référence aux dessins annexés sur lesquels :

- la figure 1 est un schéma de principe d'un système d'inspection basé sur la vélocimétrie laser à effet Doppler, décrit dans le document WO 02/39099,
- la figure 2 est un schéma de principe d'un système d'inspection selon un mode de réalisation de l'invention,
- la figure 3 est un schéma de principe d'un système optique de génération et de collection de franges d'interférence selon un mode de réalisation de l'invention,
- la figure 4 est un schéma de principe du volume de mesure comprenant des franges d'interférence selon un mode de réalisation de l'invention,
- la figure 5 est un schéma de principe d'un système d'inspection comprenant deux canaux de collecte de lumière,
- la figure 6 est un graphe représentant la résolution radiale en fonction de la position radiale du volume de mesure dans le cas du volume de mesure décrit dans le document WO 02/39099.

Pour faciliter la lecture des figures, celles-ci ne sont pas nécessairement réalisées à l'échelle.

## DESCRIPTION DETAILLEE DE L'INVENTION

On s'intéresse dans la présente invention à toute plaquette destinée à être utilisée dans le domaine de la microélectronique ou de l'optique, ladite plaquette pouvant être opaque ou au moins partiellement transparente à la longueur d'onde d'un faisceau émis par une source lumineuse. En particulier, la plaquette peut comprendre au moins l'un des matériaux suivants : silicium, germanium, verre, saphir, quartz, SiC, AsGa, GaN (liste non limitative).

L'invention utilise un volume de mesure de très petite dimension dans la direction radiale, voire également dans la direction tangentielle à la rotation de la plaquette.

Bien que cette solution aille à l'encontre de l'enseignement du document WO 02/39099, les inventeurs ont démontré, comme cela sera exposé plus bas, que ce volume de mesure sensiblement plus petit permettait d'obtenir un flux lumineux beaucoup plus élevé et, par conséquent, à puissance de fond lumineux égale, un rapport signal sur fond lumineux beaucoup plus favorable, sans pénaliser la durée d'inspection de la plaquette.

Le principe du système d'inspection 1 est illustré sur la figure 2.

Le système comprend un support 10 destiné à recevoir une plaquette 2 à inspecter et à l'entraîner en rotation autour d'un axe de symétrie X de la plaquette perpendiculaire à une surface principale S de ladite plaquette. En général, la plaquette est de forme circulaire mais l'invention peut s'appliquer à toute autre forme.

La plaquette 2 est maintenue sur le support 10 par tout moyen approprié, tel que des moyens électrostatiques, des moyens mécaniques, etc.

Le mécanisme de mise en rotation du support est connu en lui-même et ne sera donc pas décrit de manière détaillée.

Le support 10 comprend un ou plusieurs encodeurs (non illustrés) permettant de connaître à chaque instant la position angulaire de la plaquette par rapport à une position de référence.

Le système d'inspection 1 comprend en outre une source lumineuse 20.

La source lumineuse 20 est typiquement un laser de type DFB (acronyme du terme anglo-saxon « Distributed Feed Back »). Un laser de type Fabry-Pérot ayant une longueur de cohérence inférieure à $50\,\mu m$ peut dans certains cas être utilisé si la longueur des chemins optiques des deux faisceaux divisés pour former le volume de mesure est inférieure à cette longueur de cohérence.

La puissance de ladite source lumineuse est typiquement supérieure ou égale à 10 mW. En effet, en-dessous de cette puissance, la quantité de lumière diffusée par des défauts de taille inférieure à 100nm devient très faible et nécessite donc une durée d'acquisition incompatible avec l'application industrielle visée. Par ailleurs, la longueur d'onde de ladite source lumineuse est inférieure ou égale à 900nm. En effet, selon la loi de la diffusion de Mie, la puissance diffusée par un défaut de taille donnée augmente avec l'inverse de la puissance quatre de la longueur d'onde. Ainsi plus la longueur d'onde incidente sur un défaut sera faible, plus celui-ci diffusera de lumière. Utiliser une longueur d'onde supérieure à 900nm engendrera donc des quantités de lumière diffusées trop faibles pour détecter des défauts de taille inférieure à 100nm.

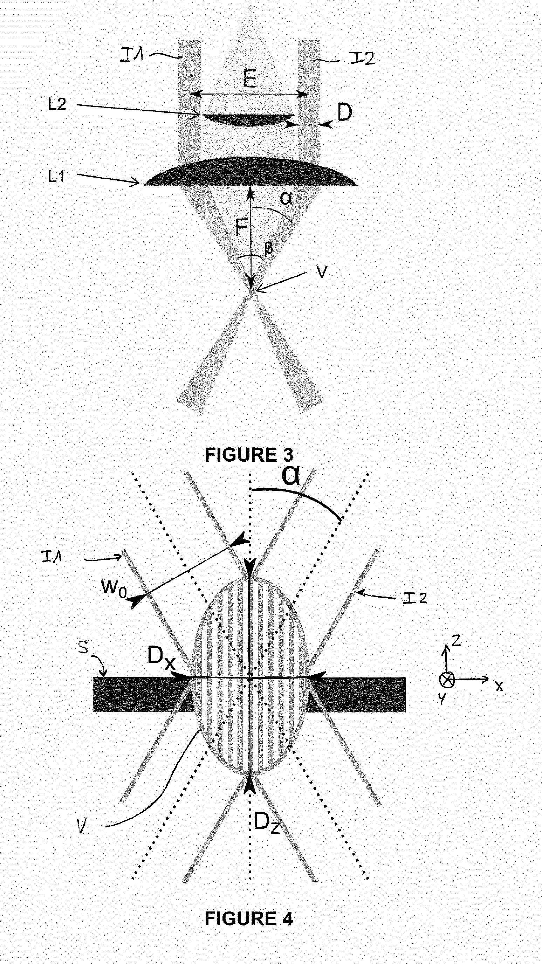

La source lumineuse est couplée à un dispositif interférométrique 30 permettant de générer un volume de mesure comprenant des franges d'interférence représenté sur la figure 3.

Le dispositif interférométrique 30 comprend un guide de lumière présentant deux branches symétriques dont l'entrée est couplée à la source lumineuse 20 pour diviser le faisceau I issu de la source lumineuse 20 en deux faisceaux incidents I1, I2. De préférence, le faisceau laser issu de la source lumineuse est collimaté. Une lentille convergente L1, par exemple convexe-plane, est placée sur le trajet des deux faisceaux incidents de sorte à dévier chacun des deux faisceaux d'un angle α pour former, à l'intersection entre les deux faisceaux, un volume de mesure V contenant des franges d'interférences. Naturellement, cette construction est donnée à titre d'exemple et tout autre dispositif permettant de former un tel volume de mesure peut être employé.

L'interfrange (distance entre deux franges adjacentes) est avantageusement compris entre 0,1 et 10 μm. En effet, un interfrange inférieur à 0,1 μm nécessiterait une fréquence d'échantillonnage plus élevée ce qui augmenterait considérablement la durée d'acquisition ou la rapidité de la chaîne d'acquisition nécessaire. Inversement, un interfrange supérieur à 10 μm impliquerait un trop petit nombre de franges au sein du volume de mesure pour faire une détection fréquentielle efficace. De plus, les défauts que la présente invention vise à qualifier étant de taille comprise entre 0,05 et 10 μm, la plage d'interfrange susmentionnée permet de discriminer efficacement des défauts dans cette gamme de tailles.

Le volume de mesure généré par un tel dispositif interférométrique est illustré schématiquement sur la figure 4.

Un repère orthonormé (x, y, z) est défini avec (x, y) dans le plan de la surface de la plaquette à inspecter et z perpendiculaire à ladite surface (la dimension du volume de mesure dans cette direction étant notée Dz). Dans cette illustration, on suppose que y s'étend dans la direction radiale (la dimension du volume de mesure dans cette direction étant notée Dy et la dimension du volume de mesure dans la direction x orthogonale à y étant notée Dy).

Dans le cas d'une plaquette opaque à la longueur d'onde de la source lumineuse, la dimension Dz ne revêt pas d'importance particulière, la surface à inspecter devant simplement passer à l'intérieur du volume de mesure.

Dans le cas d'une plaquette au moins partiellement transparente à la longueur d'onde de la source lumineuse, il est préférable de réduire autant que possible la dimension Dz afin d'avoir une résolution suffisante sur la position des éventuels défauts détectés par rapport à l'épaisseur de la plaquette. D'une manière générale, on fait en sorte que la dimension Dz soit inférieure au quart de l'épaisseur de la plaquette à inspecter. En effet, au-delà de ce ratio, de gros défauts sur la face arrière d'une plaquette transparente peuvent laisser une forte signature qui engendre des fausses détections.

Les dimensions Dx et Dy sont chacune choisies entre 5 et 100 μm, de préférence entre 15 et 50 μm. La borne inférieure égale à 5 μm est liée au fait qu'en-dessous de cette dimension, la durée d'inspection serait excessivement longue pour un procédé mis en oeuvre industriellement. La borne supérieure de 100 μm est définie pour garder un flux le plus grand possible, permettre une localisation précise des défauts à la surface de la plaquette et enfin pour diminuer la probabilité de considérer comme un seul défaut deux défauts qui viendraient à passer dans le volume de mesure simultanément.

A titre purement indicatif, le volume de mesure peut présenter des dimensions de 50*50μm dans le plan (x, y), ou encore de 20*20μm. Les dimensions du volume de mesure ne sont pas nécessairement égales dans les directions x et y.

Pour obtenir un volume de mesure aussi petit que dans la présente invention, il est généralement nécessaire que la largeur des faisceaux au niveau du volume de mesure corresponde au double du rayon minimal desdits faisceaux (« waist » selon la terminologie anglo-saxonne, notée usuellement $W_0$).

Avec D le diamètre de ces faisceaux, F la focale de la lentille L1 et λ la longueur d'onde de la source lumineuse, l'optique gaussienne permet d'obtenir la relation suivante :

$$2 * W_0 = \frac{4 \cdot F \cdot \lambda}{\pi \cdot D}$$

On peut ainsi définir la valeur de waist convenable en choisissant avantageusement la largeur des faisceaux en entrée, leur espacement et la focale de la lentille de sortie.

Par ailleurs, alors que le système décrit dans le document WO 02/39099 ne concerne que des plaquettes opaques à la longueur d'onde du faisceau, la présente invention permet d'inspecter également des substrats transparents. Dans ce cas, on cherche en outre à faire une détection qui soit la plus restreinte selon l'épaisseur du substrat, direction appelée ci-après Z ou profondeur de champ.

On suppose un volume de mesure créé par deux faisceaux issus de la même source, qui ont un waist de taille $W_0$, et qui sont incidents avec un demi-angle a.

Sauf indication contraires, les dimensions $W_0$, $D_y$, $D_x$, $D_z$ sont exprimées en largeur à $1/e^2$ de la puissance maximale.

On obtient les relations suivantes :

$$D_x = 2 * W_0$$

$$D_y = \frac{2 * W_0}{\cos(\alpha)}$$

$$D_z = \frac{2 * W_0}{\sin(\alpha)}$$

$$\frac{D_x}{D_z} = \tan(\alpha)$$

Dans le cas d'un substrat transparent, d'une épaisseur de 300 μm, on cherche à avoir par exemple une profondeur de champ Dz de l'ordre de 50 μm, avec des dimensions Dx et Dy de l'ordre de 20 μm. On recherche donc un rapport Dx/Dz = 0,4 soit un angle α de 21°.

Dans le cas où l'on recherche une détection sensible sur substrat transparent, on cherche à réduire autant que possible $W_0$ pour augmenter le flux incident : cela se fait en augmentant le diamètre du laser en amont de la lentille L1.

La diminution de Dz peut être obtenue en augmentant a.

L'invention permet donc de déterminer les paramètres pour créer un volume de mesure optimal pour la détection de petits défauts sur un substrat, y compris transparent, en faisant varier uniquement trois paramètres : la taille des faisceaux en entrée, la séparation de ces faisceaux en amont de la lentille L1 et la focale de cette lentille L1.

Revenant à la figure 2, le système d'inspection comprend par ailleurs un dispositif 40 de collecte de la lumière diffusée par la région de la plaquette traversant le volume de mesure.

Selon un mode de réalisation, ce dispositif 40 peut comprendre une fibre optique de préférence de grand diamètre de cœur (c'est-à-dire typiquement entre 50 et 2000 μm de diamètre), dont l'entrée est agencée à la focale d'un miroir ellipsoïdal ou d'une lentille d'un système de collection composé de lentilles et dont la sortie est couplée à un dispositif 50 d'acquisition de la lumière collectée pour émettre un signal électrique représentant la variation de l'intensité lumineuse de la lumière collectée en fonction du temps. Ledit dispositif 50 comprend typiquement un photodétecteur.

Selon un mode de réalisation avantageux, le dispositif 40 peut être inclus dans le dispositif 30 de génération du volume de mesure.

Ainsi, comme illustré sur la figure 3, la lentille L1 permettant de former le volume de mesure est également utilisée pour collecter la lumière diffusée par les défauts traversant le volume de mesure (chemin optique représenté par des hachures). Une seconde lentille L2 agencée en aval de la lentille L1 sur le trajet de la lumière collectée, entre les faisceaux incidents, permet de diriger la lumière collectée vers une fibre optique ou un dispositif d'acquisition (non représenté sur la figure 3). L'angle solide de collection β est alors généralement limité par l'angle des faisceaux incidents.

Plus l'angle α est grand, plus l'angle solide β est grand et la quantité de lumière collectée est importante.

D'une manière générale, on choisit un angle solide supérieur à 0,1% de la demi-sphère (ou 0,0062 stéradians). En effet, en-dessous de cette valeur, la quantité de lumière collectée devient très faible et nécessite une durée d'acquisition incompatible avec une mise en oeuvre industrielle du procédé d'inspection.

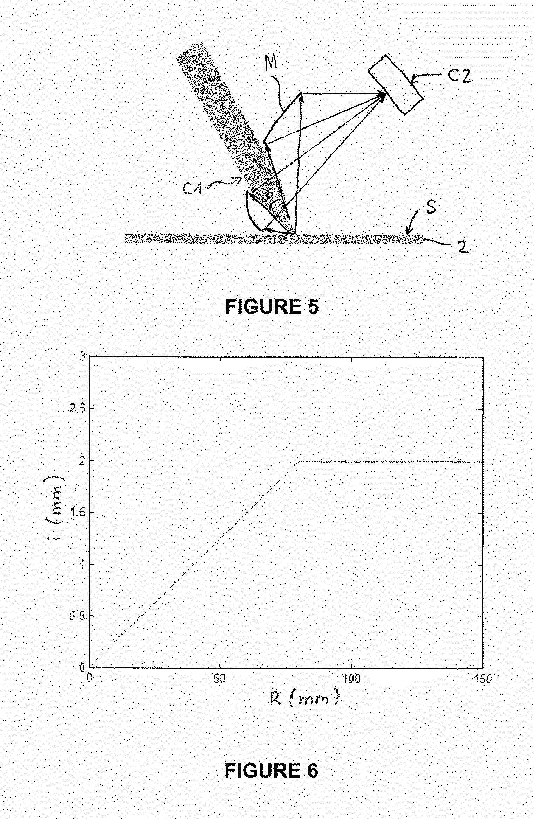

Selon une variante de réalisation, illustrée à la figure 5, il est avantageux de combiner le canal de collection C1 agencé entre les faisceaux incidents décrit plus haut avec un second canal de collection C2 utilisant un miroir de collection M agencé de sorte à collecter la lumière présentant un angle de diffusion élevé par rapport à la normale à la surface S de la plaquette inspectée.. Cette mise en oeuvre permet d'une part de collecter plus de lumière, et d'autre part d'obtenir plus d'information sur les différents défauts, chaque canal permettant d'obtenir des informations différentes selon les défauts.

Enfin, le système d'inspection 1 comprend un dispositif 60 de traitement (cf. figure 2) configuré pour détecter, dans ledit signal, une composante fréquentielle correspondant à la fréquence Doppler.

Le dispositif de traitement 60 est avantageusement couplé à une interface (non illustrée) permettant à un utilisateur d'accéder aux résultats de l'inspection afin notamment de les visualiser, de les enregistrer et/ou de les imprimer.

Pour inspecter une plaquette, on met en place ladite plaquette 2 sur le support 10 et l'on entraîne le support en rotation à une vitesse angulaire ω contrôlée. Grâce aux encodeurs présents sur le support 10, on connaît à chaque instant la position angulaire d'un point donné de la plaquette. La vitesse de rotation de la plaquette est typiquement de l'ordre de 5000 tours/min.

Dans le système d'inspection 1, le dispositif interférométrique 30 et le dispositif de collecte 40 sont agencés en regard d'une surface principale de la plaquette 2, sur un bras (non illustré) adapté pour déplacer lesdits dispositifs 30, 40 dans une direction radiale. En revanche, la source lumineuse 20 ainsi que les dispositifs d'acquisition et de traitement 50, 60 sont déportés et reliés aux dispositifs 30, 40 par des fibres optiques (non représentées). La partie mobile du système d'inspection présente donc un poids et un encombrement limités qui facilitent son déplacement, tandis que la source lumineuse, et les dispositifs d'acquisition et de traitement, qui sont encombrants, lourds et difficilement embarquables, restent immobiles. Cela permet également de réduire les longueurs de câbles de transport du signal électrique, ce qui réduit la sensibilité aux bruits électroniques environnants. Ainsi, compte tenu de la rotation de la plaquette, on peut balayer successivement l'ensemble de la surface de la plaquette avec le volume de mesure en translatant radialement le dispositif interférométrique ainsi que le dispositif de collecte de la lumière diffusée.

On fait en sorte que les franges d'interférences s'étendent transversalement à la trajectoire de rotation de la plaquette, de sorte qu'un point de la surface de la plaquette traverse au moins une frange, de préférence plusieurs franges du volume de mesure. Dans le présent texte, le terme « transversalement » signifie donc que les franges sont perpendiculaires ou inclinées d'un angle non nul par rapport à cette trajectoire.

Résultats comparatifs

*Augmentation de la sensibilité*

Le présent paragraphe présente les résultats en termes de sensibilité pour un volume de mesure de 40 $\mu$m par 2 mm (noté ci-après VM1) comme dans le document WO 02/39099 et pour un volume de mesure de 40 $\mu$m par 40 $\mu$m (noté ci-après VM2), correspondant à un mode de réalisation de la présente invention. La dimension du volume de mesure dans la direction perpendiculaire à la surface de la plaquette n'a pas d'importance dans le présent exemple.

Les conditions d'acquisition (communes aux deux configurations du volume de mesure) sont les suivantes.

La source lumineuse est un laser présentant une longueur d'onde de 488 nm et une puissance de 100 mW.

La plaquette est un substrat de silicium de 100 mm de diamètre.

L'isolation dark field (rapport du fond lumineux sur la puissance d'entrée, le fond lumineux correspondant à de la pollution lumineuse collectée) est de 90 dB.

La durée d'acquisition est de 60 s.

Le nombre de points de mesure par tour est de 1000 (résolution tangentielle).

Le défaut à détecter présente un diamètre de 100 nm, ce qui correspond à une section efficace totale, à 488 nm, de $3,5\times10^{-16}$ m$^2$ selon la théorie de Mie, utilisant une particule sphérique d'indice 1,58 dans l'air. Ce modèle donne un bon ordre de grandeur, en accord avec les mesures effectuées par les inventeurs.

La mesure choisie pour caractériser la sensibilité d'un système dark field est le rapport entre l'énergie lumineuse de signal et l'énergie lumineuse de fond.

Pour les calculs suivants, on fait l'hypothèse que la puissance de fond lumineux est uniquement liée à la qualité de la chaîne optique de collection et qu'elle est proportionnelle à la puissance lumineuse d'entrée.

Lors de la détection d'un défaut, le rapport signal sur bruit photonique (SNR-ph) - lié à la statistique de détection - est proportionnel au rapport $\mathrm{signal}/\sqrt{\mathrm{fond}}$, qui dépend donc de la puissance lumineuse d'entrée. On s'intéresse dans la suite de l'exposé au rapport signal/fond, car c'est un indicateur indépendant de la puissance lumineuse d'entrée.

On calcule le rapport signal sur fond lumineux d'un défaut de 100 nm passant dans chacun des deux volumes de mesures VM1, VM2.

La géométrie de ces deux volumes de mesure, ainsi que les paramètres communs d'acquisition décrits plus haut implique un ensemble de valeurs de puissance et d'énergie par point de mesure qui sont résumés ci-dessous :

| | Paramètres déduits | | | |
|---|---|---|---|---|
| | Flux [W/m²] | Nombre de tours | Durée d'un tour [s] | Durée d'un point d'acquisition [s] |
| VM1 | 1250000 | 25 | 2.4 | 0.0024 |
| VM2 | 62500000 | 1250 | 0.048 | 0.000048 |

| | Paramètres énergétiques déduits | | | |
|---|---|---|---|---|
| | Puissance de signal [W] | Energie de signal [J] | Energie de fond lumineux [J] | Rapport Signal sur Fond lumineux |
| VM1 | 4.4E-10 | 1.05E-12 | 2.40E-13 | 4.4 |
| VM2 | 2.2E-08 | 1.05E-12 | 4.80E-15 | 219 |

On remarque dans ces calculs que l'énergie de signal est égale dans les deux cas, ce qui provient du fait que les deux phénomènes (passage de longue durée dans un volume de mesure (VM1) au flux lumineux faible / passage de courte durée dans un volume de mesure (VM2) au flux lumineux élevé) se compensent.

L'avantage de la présente invention est centré sur l'énergie de fond lumineux collectée dans les deux cas. La puissance de fond lumineux dépend uniquement de la puissance envoyée et de la collection utilisée, qui sont les mêmes dans les deux cas. Cependant, le volume de mesure VM1 intègre à chaque point de mesure beaucoup plus de photons de fond lumineux que le volume de mesure VM2, d'où un rapport signal sur fond lumineux bien plus avantageux dans le cas du volume de mesure VM2.

Un calcul simple permet de déduire que le gain en rapport signal/fond est inversement égal au rapport des aires de chacun des volumes de mesure. Dans le cas décrit ici, $(Dx*Dy)_{VM2}/(Dx*Dy)_{VM1} = 1/50$, ce qui correspond bien à l'inverse du gain de signal/fond.

*Distinction de particules sur des substrats présentant une micro-rugosité de surface*

Il est à noter que la réduction de taille du volume de mesure est également un grand avantage dans le cas de recherche de petites particules en présence de micro-rugosité du substrat qui génère une diffusion de la lumière (« Haze » dans sa dénomination anglo-saxonne). En effet, tout substrat présente une certaine micro-rugosité qui dépend de la qualité de son polissage. Cette micro-rugosité est sensiblement homogène sur la surface et génère donc une diffusion sensiblement uniforme. En outre, contrairement aux éventuelles particules qui peuvent être présentes à la surface, toute la surface du substrat est impactée par cette micro-rugosité.

En général, cette diffusion (ou haze) est mesuré en parties par million de la puissance lumineuse incidente sur le substrat (ou PPM).

La puissance de haze mesurée ne dépend pas de la surface du volume de mesure projeté sur le substrat mais uniquement de la puissance de la source lumineuse et de la rugosité du substrat. Ainsi, pour une puissance lumineuse de 100mW et une diffusion due à la micro-rugosité de 1PPM, la puissance de Haze reçue sera de :

$$P_{haze} = P_{laser} * Haze$$

$$P_{haze} = 0.1 * 1 * 10^{-7}$$

$$P_{haze} = 10nW$$

Dans ce cas, on trouve dans les deux configurations VM1 et VM2 les résultats suivants :

|  | Puissance de Haze [W] | Puissance de signal particule de 100nm [W] | Rapport Signal / Haze |
|---|---|---|---|
| VM1 (WO 02/39099) | 1E-8 | 4.4E-10 | 0.044 |
| VM2 (présente invention) | 1E-8 | 2.2E-8 | 2.2 |

On remarque ainsi que dans le cas du volume de mesure VM1, la particule de 100nm est noyée dans le haze car sa puissance diffusée est plus de vingt fois plus faible que la puissance de haze, alors que dans le cas du volume de mesure VM2 de l'invention, la particule est bien visible dans le haze car sa puissance diffusée correspond à plus du double de la puissance du haze.
Ainsi, si on réduit l'aire du volume de mesure projeté sur la surface à inspecter d'un facteur N, le rapport Signal / Haze est augmenté de ce même facteur N.

*Augmentation de la résolution radiale*

La résolution d'un système dark field est en général déterminée par la taille du faisceau scannant la surface à inspecter.
Cependant, dans le document WO 02/39099, il est proposé un moyen d'avoir une meilleure résolution à l'aide de la variation de fréquence Doppler des défauts passant dans le volume de mesure. En effet, un défaut plus proche du centre de rotation du substrat a une vitesse linéaire plus faible qu'un défaut loin du centre de rotation du substrat. En mesurant cette fréquence Doppler, on pourrait ainsi situer avec plus de précision le défaut que la taille du faisceau.
Toutefois, même si cette théorie se vérifie, on démontre ci-après qu'en considérant les erreurs de mesure, ce gain de résolution reste très faible et ne permet en tout état de cause pas d'atteindre la résolution radiale obtenue avec la présente invention.
En effet, considérant un volume de mesure de taille 40µm*2mm avec son grand axe s'étendant de manière radiale comme décrit dans le document WO 02/39099, et un interfrange de 1 µm, on obtient alors un volume de mesure avec 40 franges.
On appelle $l$ la largeur de la bouffée en microns, $\delta$ l'interfrange, $V_t$ la vitesse de passage du défaut dans le volume de mesure, $R$ le rayon scanné, $\omega$ la vitesse angulaire de rotation, $f_d$ la fréquence Doppler du défaut détecté
L'incertitude avec laquelle on peut déterminer une fréquence est liée à la largeur du pic spectral de ladite fréquence. Or, dans le cas d'une bouffée de durée $\Delta t$, la largeur spectrale du pic est environ de $\Delta f = \frac{1}{\Delta t}$.
[2]On cherche donc à calculer $\Delta f$ en fonction du nombre de frange :

$$\Delta f = \frac{1}{\Delta t} = \frac{V_t}{l} = \frac{\delta \cdot f_d}{l}$$

On ne peut ainsi pas déterminer la fréquence Doppler $f_d$ avec une meilleure précision que $\Delta f = \frac{\delta \cdot f_d}{l}$.
Il est connu que la fréquence Doppler dans un tel système est liée à la position radiale, à l'interfrange et à la vitesse angulaire de rotation par la relation suivante :

$$f_d = \frac{\omega \cdot R}{\delta}$$

Ainsi, on peut écrire la relation sur les incertitudes suivantes :

$$\Delta f_d = \frac{\omega}{\delta} \cdot \Delta R$$

Les valeurs $\omega$ et $R$ étant ici constantes.

On obtient donc pour une incertitude $\Delta f_d$ donnée une incertitude sur la position radiale qui est

$$\Delta R = \frac{\delta}{\omega} \cdot \Delta f_d$$

Ainsi on peut conclure par :

$$\Delta R = \frac{\delta}{\omega} \cdot \frac{\delta}{l} f_d = \frac{\delta}{l} \cdot R$$

Cette relation permet ainsi de lier l'incertitude sur la position radiale déterminée à l'aide de la fréquence Doppler au rayon scanné, à l'interfrange et à la largeur du volume de mesure. Cette incertitude i, qui est dans ce cas égale à la résolution radiale, est tracée sur la figure 6 en fonction du rayon R pour les valeurs données précédemment.

On observe dans cet exemple que le volume de mesure présenté dans le document WO 02/39099 que la résolution radiale diminue très vite avec le rayon scanné, avant d'être finalement limitée par la taille du volume de mesure lui-même (plateau à partir de 80mm de rayon scanné). Par exemple, si on veut une résolution radiale de $50\mu$m, on est limité à un rayon de scan de 2mm. Pour avoir une résolution radiale de $50\mu$m sur une plaquette de 300mm de rayon avec un interfrange de $1\mu$m, on doit alors avoir un volume de mesure de $333\mu$m de large, ce qui réduit encore le flux lumineux (cf. considérations précédentes sur la sensibilité).

Au contraire, un des avantages de la présente invention est que la résolution radiale est définie à minima par la taille du volume de mesure. Pour compenser la plus petite taille du volume de mesure, le procédé selon l'invention nécessite une rotation plus rapide de la plaquette que dans le document WO 02/39099 pour conserver une même durée d'inspection. Toutefois, la vitesse nécessaire est aisément atteinte, des dispositifs de rotation rapide (« spindle » selon la terminologie anglo-saxonne) permettant de faire tourner des plaquettes jusqu'à 300mm de diamètre à des vitesses de plusieurs milliers de tours par minute. En outre, des photodétecteurs et des cartes d'acquisition de données fonctionnant à des fréquences compatibles avec ces vitesses et les fréquences Doppler qui en découlent sont également disponibles.

**REFERENCES**

WO 2009/112704
WO 02/39099

**Revendications**

**1.** Procédé d'inspection d'une plaquette (2) pour l'électronique, l'optique ou l'optoélectronique, comprenant :

- la mise en rotation de la plaquette (2) autour d'un axe de symétrie (X) perpendiculaire à une surface principale (S) de ladite plaquette,
- l'émission, à partir d'une source lumineuse (20) couplée à un dispositif interférométrique (30), de deux faisceaux lumineux incidents de sorte à former, à l'intersection entre les deux faisceaux, un volume de mesure (V) contenant des franges d'interférences agencées de telle sorte qu'une région de la surface principale (S) de la plaquette traverse au moins une frange du volume de mesure, la dimension (Dy) dudit volume de mesure dans une direction radiale de la plaquette étant comprise entre 5 et 100 $\mu$m,
- la collecte d'au moins une partie de la lumière diffusée par ladite région de la plaquette,
- l'acquisition de la lumière collectée et l'émission d'un signal électrique représentant la variation de l'intensité lumineuse de la lumière collectée en fonction du temps,
- la détection, dans ledit signal, d'une composante fréquentielle dans ladite lumière collectée, ladite fréquence étant la signature temporelle du passage d'un défaut dans le volume de mesure.

**2.** Procédé selon la revendication 1, dans lequel la dimension (Dx) du volume de mesure dans une direction tangentielle à la trajectoire de rotation de la plaquette est compris entre 5 et 100 $\mu$m, de préférence entre 15 et 50 $\mu$m.

**EP 3 436 807 B1**

3. Procédé selon l'une des revendications 1 ou 2, dans lequel la plaquette est au moins partiellement transparente à la longueur d'onde de la source lumineuse.

4. Procédé selon la revendication 3, dans lequel la dimension (Dz) du volume de mesure dans une direction perpendiculaire à la surface de la plaquette est inférieure ou égale au quart de l'épaisseur de ladite plaquette.

5. Procédé selon l'une des revendications 1 ou 2, dans lequel, à l'emplacement du volume de mesure, les faisceaux incidents présentent une largeur minimale ($2*W_0$).

6. Procédé selon l'une des revendications 1 à 3, dans lequel la puissance de la source lumineuse est supérieure ou égale à 10 mW.

7. Procédé selon l'une des revendications 1 à 4, dans lequel la longueur d'onde de la source lumineuse est inférieure ou égale à 900 nm.

8. Procédé selon l'une des revendications 1 à 7, dans lequel l'interfrange est compris entre 0,1 et 10 $\mu$m.

9. Système (1) d'inspection de plaquettes (2) pour la microélectronique ou l'optique, comprenant :

   - un dispositif (10) d'entraînement d'une plaquette en rotation autour d'un axe (X) de symétrie perpendiculaire à une surface principale (S) de ladite plaquette,
   - une source lumineuse (20) adaptée pour émettre un faisceau lumineux,
   - un dispositif interférométrique (30) couplé à la source lumineuse pour diviser le faisceau émis par ladite source (20) en deux faisceaux et pour former, à l'intersection entre les deux faisceaux, un volume de mesure (V) contenant des franges d'interférences, la dimension (Dy) dudit volume de mesure dans une direction radiale de la plaquette étant comprise entre 5 et 100 $\mu$m, le dispositif interférométrique (30) et le dispositif d'entraînement (10) étant agencés l'un par rapport à l'autre de sorte qu'une région de la surface principale de la plaquette en rotation traverse au moins une frange du volume de mesure,
   - un dispositif (40) de collecte de la lumière diffusée par la plaquette,
   - un dispositif (50) d'acquisition de la lumière collectée configuré pour émettre un signal électrique représentant la variation de l'intensité lumineuse de la lumière collectée en fonction du temps,
   - un dispositif (60) de traitement configuré pour détecter, dans ledit signal, une composante fréquentielle dans ladite lumière collectée, ladite fréquence étant la signature temporelle du passage d'un défaut dans un volume de mesure respectif et pour déterminer, à partir de ladite fréquence, la position du défaut dans la direction radiale et/ou dans l'épaisseur de la plaquette.

10. Système selon la revendication 9, comprenant en outre un bras pour déplacer le dispositif interférométrique (30) et le dispositif (40) de collecte de la lumière diffusée en translation dans une direction radiale, la source lumineuse, le dispositif d'acquisition et le dispositif de traitement étant immobiles.

11. Système selon la revendication 10, dans lequel ledit dispositif interférométrique est couplé à la source lumineuse par une fibre optique et ledit dispositif de collecte est couplé au dispositif d'acquisition par une fibre optique.

**Patentansprüche**

1. Verfahren zur Prüfung eines Wafers (2) für die Elektronik, die Optik oder die Optoelektronik, umfassend:

   - das Versetzen des Wafers (2) in eine Drehbewegung um eine senkrecht zu einer Hauptoberfläche (S) des Wafers verlaufende Symmetrieachse (X),
   - das Aussenden von zwei einfallenden Lichtstrahlen, von mindestens einer mit einer interferometrischen Vorrichtung (30) gekoppelten Lichtquelle (20) ausgehend, sodass an dem Knotenpunkt zwischen den zwei Strahlen ein Messvolumen (V) gebildet wird, welches derart angeordnete Interferenzstreifen enthält, dass ein Bereich der Hauptoberfläche (S) des Wafers durch mindestens einen Streifen des Messvolumens hindurch verläuft, wobei die Abmessung (Dy) des Messvolumens in einer Radialrichtung des Wafers zwischen 5 und 100 $\mu$m ist,
   - das Sammeln mindestens eines Teils des durch den Bereich des Wafers gestreuten Lichts,
   - die Erfassung des gesammelten Lichts und die Ausgabe eines elektrischen Signals, das die Veränderung der Lichtintensität des gesammelten Lichts in Abhängigkeit der Zeit darstellt,

- die in dem Signal erfolgende Erkennung einer Frequenzkomponente in dem gesammelten Licht, wobei die Frequenz die Zeitsignatur eines das Messvolumen durchlaufenden Fehlers ist.

2. Verfahren nach Anspruch 1, wobei die Abmessung (Dx) des Messvolumens in einer Richtung tangential zur Rotationsbahn des Wafers zwischen 5 und 100 $\mu$m, vorzugsweise zwischen 15 und 50 $\mu$m ist.

3. Verfahren nach einem der Ansprüche 1 oder 2, wobei der Wafer bei der Wellenlänge der Lichtquelle mindestens teilweise durchsichtig ist.

4. Verfahren nach Anspruch 3, wobei die Abmessung (Dz) des Messvolumens in einer Richtung senkrecht zur Oberfläche des Wafers kleiner oder gleich einem Viertel der Dicke des Wafers ist.

5. Verfahren nach einem der Ansprüche 1 oder 2, wobei an der Position des Messvolumens die einfallenden Lichtstrahlen eine Mindestweite (2*$W_0$) aufweisen.

6. Verfahren nach einem der Ansprüche 1 bis 3, wobei die Leistung der Lichtquelle größer oder gleich 10 mW ist.

7. Verfahren nach einem der Ansprüche 1 bis 4, wobei die Wellenlänge der Lichtquelle kleiner oder gleich 900 nm ist.

8. Verfahren nach einem der Ansprüche 1 bis 7, wobei der Streifenabstand zwischen 0,1 und 10 $\mu$m ist.

9. System (1) zur Prüfung von Wafern (2) für die Mikroelektronik oder die Optik, umfassend:

- eine Antriebsvorrichtung (10) zum Versetzen eines Wafers in Drehbewegung um eine senkrecht zu einer Hauptoberfläche (S) des Wafers verlaufende Symmetrieachse (X),
- eine zum Aussenden eines Lichtstrahls geeignete Lichtquelle (20),
- eine interferometrische Vorrichtung (30), welche mit der Lichtquelle zur Teilung des durch die Lichtquelle (20) ausgesendeten Strahls in zwei Strahlen und zur Bildung eines Messvolumens (V) mit Interferenzstreifen an dem Knotenpunkt zwischen den zwei Strahlen gekoppelt ist, wobei die Abmessung (Dy) des Messvolumens in einer Radialrichtung des Wafers zwischen 5 und 100 $\mu$m ist, wobei die interferometrische Vorrichtung (30) und die Antriebsvorrichtung (10) derart zu einander angeordnet sind, dass ein Bereich der Hauptoberfläche des sich drehenden Wafers mindestens einen Streifen des Messvolumens durchläuft,
- eine Vorrichtung (40) zum Sammeln des durch den Wafer gestreuten Lichts,
- eine Vorrichtung (50) zur Erfassung des gesammelten Lichts, ausgestaltet zur Ausgabe eines elektrischen, die zeitabhängige Veränderung der Lichtintensität des gesammelten Lichts darstellenden Signals,
- eine Verarbeitungsvorrichtung (60), dazu ausgestaltet, in dem Signal eine Frequenzkomponente im gesammelten Licht zu erkennen, wobei die Frequenz die Zeitsignatur eines ein jeweiliges Messvolumen durchlaufenden Fehlers ist, und ausgehend von der Frequenz die Position des Fehlers in der Radialrichtung und/oder in der Dicke des Wafers festzustellen.

10. System nach Anspruch 9, außerdem umfassend einen Arm zur translationsartigen Verschiebung in einer radialen Richtung der interferometrischen Vorrichtung (30) und der Vorrichtung (40) zum Sammeln des gestreuten Lichts, wobei die Lichtquelle, die Erfassungsvorrichtung und die Verarbeitungsvorrichtung unbeweglich sind.

11. System nach Anspruch 10, wobei die interferometrische Einrichtung über eine optische Faser mit der Lichtquelle gekoppelt ist und wobei die Sammelvorrichtung über eine optische Faser mit der Erfassungsvorrichtung gekoppelt ist.


**Claims**

1. Method for inspecting a wafer (2) for electronics, optics or optoelectronics, comprising:

- rotating the wafer (2) about an axis of symmetry (X) perpendicular to a main surface (S) of said wafer,
- emitting, from a light source (20) coupled with an interferometric device (30), two incident light beams, so as to form, at the intersection between the two beams, a measurement volume (V) containing interference fringes arranged such that a region of the main surface (S) of the wafer passes through at least one fringe of the measurement volume, the dimension (Dy) of said measurement volume in a radial direction of the wafer being comprised between 5 and 100 $\mu$m,

- collecting at least a portion of the light scattered by said region of the wafer,
- acquiring the collected light and emitting an electrical signal representing the variation in the light intensity of the collected light as a function of time,
- detecting, in said signal, a frequency component in said collected light, said frequency being the time signature of the passage of a defect through the measurement volume.

2. Method according to claim 1, in which the dimension (Dx) of the measurement volume in a direction tangential to the path of rotation of the wafer is comprised between 5 and 100 $\mu$m, preferably between 15 and 50 $\mu$m.

3. Method according to one of claims 1 or 2, in which the wafer is at least partially transparent at the wavelength of the light source.

4. Method according to claim 3, in which the dimension (Dz) of the measurement volume in a direction perpendicular to the surface of the wafer is less than or equal to a quarter of the thickness of said wafer.

5. Method according to one of claims 1 or 2, in which, at the location of the measurement volume, the incident beams have a minimum width (2 x $W_0$).

6. Method according to one of claims 1 to 3, in which the power of the light source is greater than or equal to 10 mW.

7. Method according to one of claims 1 to 4, in which the wavelength of the light source is less than or equal to 900 nm.

8. Method according to one of claims 1 to 7, in which the inter-fringe distance is comprised between 0.1 and 10 $\mu$m.

9. System (1) for inspecting wafers (2) for microelectronics or optics, comprising:

- a device (10) for driving a wafer in rotation about an axis (X) of symmetry perpendicular to a main surface (S) of said wafer,
- a light source (20) suitable for emitting a light beam,
- an interferometric device (30) coupled with the light source in order to split the beam emitted by said source (20) into two beams and in order to form, at the intersection between the two beams, a measurement volume (V) containing interference fringes, the dimension (Dy) of said measurement volume in a radial direction of the wafer being comprised between 5 and 100 $\mu$m, the interferometric device (30) and the drive device (10) being arranged in relation to one another so that a region of the main surface of the wafer in rotation passes through at least one fringe of the measurement volume,
- a device (40) for collecting light scattered by the wafer,
- a device (50) for acquiring collected light configured in order to emit an electrical signal representing the variation in the light intensity of the collected light as a function of time,
- a processing device (60) configured in order to detect, in said signal, a frequency component in said collected light, said frequency being the time signature of the passage of a defect through a respective measurement volume and in order to determine, based on said frequency, the position of the defect in the radial direction and/or in the thickness of the wafer.

10. System according to claim 9, also comprising an arm for moving the interferometric device (30) and the device (40) for collecting scattered light in translational motion in a radial direction, the light source, the acquisition device and the processing device being immobile.

11. System according to claim 10, in which said interferometric device is coupled with the light source by an optical fibre and said collection device is coupled with the acquisition device by an optical fibre.

13

**FIGURE 1**

**FIGURE 2**

**FIGURE 3**

**FIGURE 4**

**FIGURE 5**

**FIGURE 6**

**EP 3 436 807 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0239099 A

- WO 2009112704 A

**17**